# EUROPÄISCHE PATENTSCHRIFT

(11) **EP 2 871 766 B1**
(45) Veröffentlichungstag und Bekanntmachung des Hinweises auf die Patenterteilung: **16.08.2017**
(21) Anmeldenummer: 14186232.6
(22) Anmeldetag: 24.09.2014
(51) Int. Cl.: H02M 7/487, H03K 17/689, H03K 17/687

(54) **Ansteuerschaltung für Drei-Level-Inverter**
Control circuit for three level inverter
Commutateur de commande pour onduleur à trois niveaux

(30) Priorität: 07.11.2013 DE 102013112262
(43) Veröffentlichungstag der Anmeldung: 13.05.2015
(73) Patentinhaber: SEMIKRON Elektronik GmbH & Co. KG, 90431 Nürnberg (DE)
(72) Erfinder: Herzer, Reinhard, 98693 Ilmenau (DE); Vogler, Bastian, 90763 Fürth (DE)

(56) Entgegenhaltungen:
- WO-A1-2013/007788
- US-A1- 2003 112 040
- US-A1- 2006 050 455
- US-A1- 2011 058 399
- SCHWEIZER M. ET AL: "DESIGN AND IMPLEMENTATION OF A HIGHLY EFFICIENT THREE-LEVEL T-TYPE CONVERTER FOR LOW-VOLTAGE APPLICATIONS", IEEE POWER ELECTRONICS, Bd. 28, Nr. 2, 2. Februar 2013 (2013-02-02), Seiten 899-907, XP002737814,

## Beschreibung

Die Erfindung beschreibt eine Ansteuerschaltung mit einer Mehrzahl von Levelshiftern zur Übertragung von Ansteuersignalen von einer Ansteuerlogik mit einem ersten Bezugspotential zu Treiberstufen mit zumindest teilweise unterschiedlichen weiteren Bezugspotentialen. Grundsätzlich werden derartige Ansteuerschaltungen in leistungselektronischen Systemen benötigt, um Halbleiterschalter anzusteuern, die als Einzelschalter oder in einer Brückenschaltung angeordnet sind. Derartige Brückenschaltungen sind als Ein-, Zwei- oder Dreiphasen-Brückenschaltungen bekannt, wobei die einphasige sog. Halbbrückenschaltung einen Grundbaustein einer Vielzahl von leistungselektronischen Schaltungen darstellt. In einer Zwei-Level-Halbbrückenschaltung sind zwei Leistungsschalter, ein erster, unterer sog. BOT-Schalter und ein zweiter, oberer sog. TOP- Schalter in einer Reihenschaltung angeordnet. Eine derartige Halbbrücke weist in der Regel eine Verbindung zu einem Gleichspannungszwischenkreis auf. Der Ausgang, ausgebildet als Wechselspannungsanschluss der Halbbrücke, ist fachüblich mit einer Last verbunden.

Durch das alternierende Schalten von TOP- und BOT-Schalter variiert die Ausgangsspannung bei der Halbbrückenschaltung zwischen den festen Spannungswerten des positiven und des negativen Spannungsanschlusses an den Zwischenkreises. Da somit zwei stationäre Spannungszustände existieren, wird diese Halbbrückenschaltung als Zwei-Level-Halbbrückenschaltung oder Zwei-Level-Inverter bezeichnet.

Neben der Zwei-Level-Halbbrückenschaltung sind auch komplexere Brückenschaltungen bekannt, mit denen drei oder mehr stationäre Spannungszustände schaltbar sind. Diese bezeichnet man als Multi-Level-Inverter. Der Vorteil von Multi-Level-Invertern ist, dass der Verlauf der Ausgangsspannung näher dem erwünschten sinusförmigen Verlauf angenähert werden kann. Dadurch kann die gesamte harmonische Verzerrung (Total Harmonic Distortion, THD) des Ausgangsstroms reduziert werden, wodurch kleinere und kostengünstigere Netzfilter eingesetzt werden können. Andererseits können mittels Multi-Level-Invertern gegenüber Zwei-Level-Invertern gleiche Werte der TDH mit niedrigerer Schaltfrequenz erreicht werden, wodurch geringere Schaltverluste entstehen. Nachteilig bei Multi-Level-Invertern sind allerdings der erhöhte Aufwand für die Regelung, sowie die höhere Anzahl an notwendigen Bauelementen und Ansteuerschaltungen.

Die einfachste Ausgestaltung eines Multi-Level-Inverters ist der Drei-Level-Inverter mit drei schaltbaren Spannungszuständen. Grundsätzlich sind zwei Topologien für Drei-Level-Inverter bekannt, denen gemeinsam ist, dass sie fachüblich durch zwei in Reihe geschaltete Hochspannungszwischenkreise, mit einem positiven und einem negativem Anschluss gespeist wewrden. Der Mittelpunkt der Reihenschaltung wird als Neutralknoten bezeichnet und liegt fachüblich auf Erdpotential. Der Neutralknoten wird als dritter Spannungszustand verwendet.

Ansteuerschaltungen für Drei-Level-Inverter werden fachüblich mit galvanischer Trennung zwischen einer Primärseite und mehreren Sekundärseiten ausgeführt. Die Ansteuerschaltung besteht dabei aus mehreren Teilschaltungen bzw. Funktionsblöcken. Die Ansteuersignale einer übergeordneten Steuerlogik, beispielhaft einem Mikrokontroller, werden in einem ersten primärseitigen Schaltungsteil, der Ansteuerlogik aufbereitet. Das Bezugspotential des primärseitigen Schaltungsteils liegt dabei auf dem geerdeten Neutralknoten. Die Übertragung der Ansteuersignale zu den sekundärseitigen Schaltungsteilen erfolgt galvanisch getrennt über transformatorisch arbeitende Impulsübertrager oder optisch über Optokoppler oder Lichtwellenleiter. Die Treiberstufen als Teil des sekundärseitigen Schaltungsteils steuern die Halbleiterschalter, beispielhaft IGBTs, entsprechend der übertragenen Ansteuersignale an.

Grundsätzlich können alle primärseitigen sowie die jeweiligen sekundärseitigen Funktionen jeweils in monolithisch integrierten Schaltungen zusammengefasst werden. Die benötigten galvanisch trennenden Potentialtrennglieder sind nach dem Stand der Technik jedoch nicht mit integrierbar, so dass üblicherweise die Funktionsblöcke des primärseitigen Schaltungsteils und der sekundärseitigen Schaltungsteils zusammen mit dem Potentialtrennglied diskret auf einer Leiterplatte (PCB - Printed Circuit Board) aufgebaut werden.

Für Zwei-Level-Inverter sind Ansteuerschaltungen mit Potentialtrennung in integrierter Schaltungstechnik, beispielhaft in einem Hochspannungsschaltkreis (HVIC - High Voltage Integrated Circuit), grundsätzlich bekannt. HVICs werden aufgrund verschiedener Vorteile, wie geringes Volumen, niedriger Preis und lange Lebensdauer, zunehmend eingesetzt. Dabei bieten HVICs zum einen die Möglichkeit, die Potentialtrennung zwischen der primärseitigen Ansteuerschaltung und der sekundärseitigen Treiberschaltung zu realisieren, und zum anderen einen Levelshifter mit einem Hochspannungsbauelement, mit einer Durchbruchspannung des HVICs entsprechend der Potentialdifferenz zu integrieren, welcher zur Signalübertragung zwischen dem primär- und dem sekundärseitigen Schaltungsteil eingesetzt werden kann.

Ein derartiger Levelshifter kann Teil der Ansteuerschaltung und im HVIC integriert ausgeführt sein. Er dient der Übertragung eines Signals von einem primärseitigen Schaltungsteil mit einem definierten Bezugspotential zu einem sekundärseitigen Schaltungsteil mit einem zeitweise höheren oder auch niedrigeren Bezugspotential.

Weiterhin sind grundsätzlich zwei Isolationstechnologien zur Ausbildung von HVICs bekannt. Einerseits die SOI-(Silicon on Insulator) Technologien und andererseits pnisolierte Technologien (Junction Isolation). Die SOI-Technologie bietet eine dielektrische Potentialtrennung von Bauelementen oder Bauelementgruppen, steht aber derzeit auf Grund der begrenzten Spannungsfestigkeit nur bis 800V Potentialdifferenz zur Verfügung. Bei pn- isolierten Technologien wird die Potentialdifferenz von einen sperrgepolten pn- Übergang aufgenommen. Diese Technik steht derzeit bis 1200V Potentialdifferenz zur Verfügung.

Eine einfache Ausgestaltung eines Levelshifters besteht aus einem Hochspannungstransistor (HV-Transistor) mit der zu überbrückenden Potentialdifferenz entsprechenden Sperrfähigkeit und einem Widerstand in Reihenschaltung. Wird auf dem primärseitigen Schaltungsteil ein Signal auf das Gate des HV-Transistors gegeben, schaltet dieser ein. Der dadurch erzeugte Querstrom durch den Levelshifter verursacht einen Spannungsabfall über dem Widerstand, der als Signal von einer Auswerteschaltung auf dem sekundärseitigen Schaltungsteil erfasst werden kann. Derartige Levelshifter mit HV-Transistoren enthalten Prinzip bedingt einen zur Signalübertragung notwendigen Querstrompfad, so dass eine Potentialtrennung, aber keine galvanische Trennung vorliegt.

In der DE 101 52 930 A1 wird eine erweiterte Levelshiftertopologie offenbart, bei der das Ansteuersignal schrittweise, mittels einer Mehrzahl gleichartiger, kaskadiert geschalteter Levelshifter, über Zwischenpotentiale übertragen wird. Damit sind Transistoren einsetzbar, die nur den Bruchteil der geforderten Sperrfähigkeit des gesamten Levelshifters besitzen. Somit kann die Sperrfähigkeit des Levelshifters wesentlich erhöht werden.

Die DE 10 2006 037 336 A1 offenbart einen Levelshifter ausgeführt als eine Reihenschaltung von HV-Transistoren vom n-Kanal-Typ. Diese Topologie weist die Vorteile auf, dass gegenüber derjenigen gemäß DE 101 52 930 A1 zum einen der Leistungsverbrauch und zum anderen der Schaltungsaufwand verringert sind. Dies hat insbesondere einen geringeren Platzbedarf zur Folge.

Allen genannten Ausgestaltungen für HVICs ist gemein, dass bei komplementärem Aufbau des Levelshifters auch eine Signalübertragung von einem Schaltungsteil mit einem hohen Bezugspotential zu einem Schaltungsteil mit einem niedrigen Bezugspotential grundsätzlich möglich ist. Diese Eigenschaft kann somit für eine Signalrückübertragung vom sekundärseitigen zum primärseitigen Schaltungsteil und somit zur dortigen Ansteuerlogik genutzt werden. Voraussetzung hierfür ist allerdings ein HV-Transistor vom p-Kanal-Typ.

Durch parasitäre Induktivitäten eines Systems aus einem Leistungshalbleitermodul und einer Ansteuerschaltung kann es während schnellen Schaltens der Leistungsschalter zu einem starken Verriss des jeweiligen Bezugspotentials der sekundärseitigen Schaltungsteile meist in positiver aber auch negativer Richtung unter das ansteuerseitige Bezugspotential kommen. Dies tritt in besonders starkem Maße in Systemen mittlerer und hoher Leistung auf, bei denen große Ströme, insbesondere größer 50A, geschaltet werden. Die meisten, heute verfügbaren Levelshifter sind allerdings nicht für eine derartige Signalübertragung in negativer Richtung ausgelegt. Auch weisen die bekannten pn-Isolationstechnologien den Nachteil auf, dass bei einem entsprechenden Verriss des Bezugspotentials in negative Richtung die Sperrfähigkeit zwischen dem primär- und dem sekundärseitigen Schaltungsteil verloren geht und der fließende Leckstrom zum Zünden parasitärer Thyristorstrukturen, dem sog. Latch-up, führen kann. Dies führt zum Funktionsverlust und eventuell zur Zerstörung der betroffenen Schaltungen.

Eine derartige Einschränkung ist, bedingt durch die dielektrische Isolation und die damit verbundene bidirektionale Sperrfähigkeit der Isolationsgebiete, bei SOI-Technologien nicht gegeben, so dass Übertragungsschaltungen schaltungstechnisch umsetzbar sind, die auch bei kurzzeitig oder dauerhaft negativem sekundärseitigem Bezugspotential eine sichere Signalübertragung und Isolation gewährleisten. Die DE 10 2006 050 913 A1 offenbart einen derartigen Levelshifter für eine BOT-Sekundärseite ausgeführt in SOI- Technologie mit jeweils einem UP- und DOWN-Levelshifterzweig, während die DE 10 2007 006 319 A1 einen derartigen Levelshifter für eine TOP-Sekundärseite ebenso in SOI- Technologie ausgeführt als UP- und DOWN- Levelshifterzweig offenbart.

Weiterhin zählt die US 2006/0050455 A1 zum Stand der Technik. Diese offenbart ein Ansteuersystem für eine Halbbrückenschaltung mit einer übergeordneten Steuerung, einer Schnittstellenschaltung und einer Ansteuerschaltung mit einem primärseitigen Schaltungsteil, einer Ansteuerlogik mit einem primärseitigen Bezugspotential und sekundärseitigen Schaltungsteilen jeweils mit einer Treiberstufe ausgebildet zur Ansteuerung einer Halbbrückenschaltung mit, einem negativen und einem positiven Spannungsanschluss, einer Mehrzahl von Halbleiterschaltern, wobei jeder Halbleiterschalter und die ihm zugeordnete Treiberstufe ein zugeordnetes sekundärseitiges Bezugspotential aufweist, wobei jeweils ein Ansteuer-Levelshifter den primärseitigen Schaltungsteil mit dem jeweiligen sekundärseitigen Schaltungsteil verbindet und somit jeweils beiden Schaltungsteilen zugeordnet ist, wobei Schnittstellen-Levelshifter die Schnittstellenschaltung mit der Ansteuerlogik der Ansteuerschaltung verbinden und wobei die Schnittstellenschaltung, die Schnittstellen-Levelshifter, die Ansteuerlogik ein unterer Ansteuer-Levelshifter sowie die damit verbundene untere Treiberstufe in einem HVIC monolithisch integriert sind.

Der Erfindung liegt die Aufgabe zugrunde eine Ansteuerschaltung zur Ansteuerung von Drei-Level-Invertern mit symmetrisch gespeistem Zwischenkreis in Form einer zumindest teilweise monolithisch integrierten Schaltung vorzustellen, die in einem Gehäuse oder auf einem Substrat, insbesondere auf einer Leiterbahn eines metallisierten Keramiksubstrats eines Leistungshalbleitermoduls, aufgebaut werden kann.

Diese Aufgabe wird erfindungsgemäß gelöst durch eine Ansteuerschaltung mit den Merkmalen des Anspruchs 1. Bevorzugte Ausführungsformen sind in den abhängigen Ansprüchen beschrieben.

Die Erfindung betrifft eine Ansteuerschaltung mit einem primärseitigen Schaltungsteil mit einer Ansteuerlogik und einem primärseitigen Bezugspotential und vier sekundärseitigen Schaltungsteilen jeweils mit einer Treiberstufe ausgebildet zur Ansteuerung einer Phase eines Drei-Level-Inverters mit jeweils einem ersten bis vierten Halbleiterschalter, wobei jeder Halbleiterschalter und der ihm zugeordnete sekundärseitige Schaltungsteil ein zugeordnetes erstes bis viertes sekundärseitiges Bezugspotential aufweist, wobei durchaus zwei sekundärseitige Bezugspotentiale gleich sein können. Hierbei verbindet jeweils ein Levelshifter den primärseitigen Schaltungsteil mit dem jeweiligen sekundärseitigen Schaltungsteil und ist somit jeweils beiden Schaltungsteilen zugeordnet. Bei dieser Ansteuerschaltung entspricht das primärseitige Bezugspotential dem ersten sekundärseitigen Bezugspotential, die beiden Potentiale sind also gleich. Weiterhin sind zumindest die Ansteuerlogik der erste und zweiter Levelshifter sowie die erste und zweite Treiberstufe monolithisch in einem HVIC integriert. Die monolithische Integration, auch die weiter unten genannte erfolgt vorzugsweise in SOI- Technologie.

Es kann vorteilhaft sein, wenn die Halbleiterschalter des Drei-Level-Inverters in Reihe oder in T-Topologie geschaltet sind und wenn hierbei der erste Halbleiterschalter mit einem negativen Spannungsanschluss und der vierte Halbleiterschalter mit einem positiven Spannungsanschluss des Drei-Level-Inverters verbunden sind.

Es ist insbesondere bevorzugt, wenn die Ansteuerlogik sowie alle Levelshifter und alle Treiberstufen monolithisch integriert sind.

Alternativ kann auch der dritte und vierte Levelshifter aus jeweils zwei Teillevelshiftern ausgebildet sein, wobei der jeweils erste Teillevelshifter gemeinsam mit der Ansteuerlogik und dem ersten und zweiten Levelshifter und der ersten und zweiten Treiberstufe auf einem ersten HVIC monolithisch integriert sind, und wobei die jeweils zweiten Teillevelshifter mit der zugeordneten Treiberstufe monolithisch auf einem zweiten bzw. dritten HVIC integriert sind.

Hierbei kann der erste, zweite und dritte HVIC in einem Multichipmodul mit gemeinsamen Gehäuse verbaut sein, oder jeder HVIC auf einer Leiterbahn angeordnete sein, die zu den anderen Leiterbahn eines Leistungshalbleitermoduls elektrisch isoliert ist.

In der Ansteuerschaltung kann mindestens ein Levelshifter dazu ausgebildet sein ein Ansteuersignal von dem primärseitigen Schaltungsteil zum zugeordneten sekundärseitigen Schaltungsteil unidirektional zu übertragen oder dazu ausgebildet sein ein Ansteuersignal und ein Rücksignal zu übertragen und somit eine bidirektionale Übertragung bereitzustellen.

Vorteilhafterweise ist ein Halbleiterschalter ausgebildet aus mindestens einem Leistungstransistor, insbesondere einem IGBT mit antiparallel geschalteter Freilaufdiode, wobei das Potential des Emitters des IGBT dessen Bezugspotential darstellt.

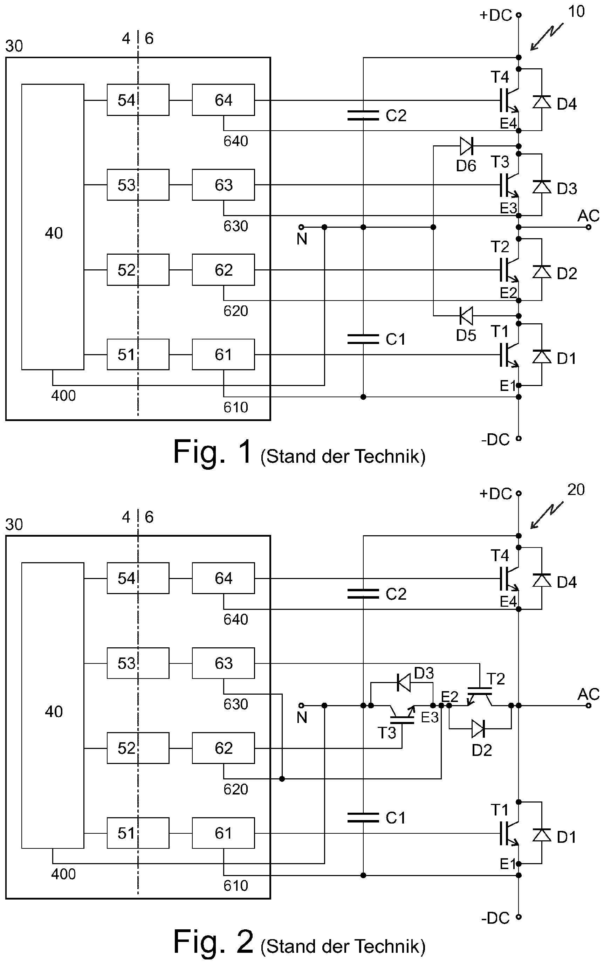

Es versteht sich, dass die verschiedenen Ausgestaltungen der Erfindung einzeln oder in beliebigen sich nicht per se ausschließenden Kombinationen realisiert sein können, um Verbesserungen zu erreichen. Weitere Erläuterung der Erfindung, vorteilhafte Einzelheiten und Merkmale, ergeben sich aus der nachfolgenden Beschreibung der in den Fig. 1 bis 6 dargestellten Ausführungsbeispiele der erfindungsgemäßen Anordnung oder von Teilen hiervon.
Figur 1 zeigt eine Ansteuerschaltung für einen Drei-Level-Inverter mit erster Topologie nach dem Stand der Technik.
Fig. 2 zeigt eine Ansteuerschaltung für einen Drei-Level-Inverter mit zweiter Topologie nach dem Stand der Technik.
Fig. 3 zeigt eine erfindungsgemäße Ansteuerschaltung für einen Drei-Level-Invertern mit erster Topologie.
Fig. 4 zeigt eine erfindungsgemäße Ansteuerschaltung für einen Drei-Level-Invertern mit zweiter Topologie.
Fig. 5 zeigt eine Variation der Ansteuerschaltung gemäß Fig. 4.
Fig. 6 zeigt eine weitere erfindungsgemäße Ansteuerschaltung.

Fig. 1 zeigt eine erste Topologie eines Drei-Level-Inverter 10 nach dem Stand der Technik mit dazugehöriger Ansteuerschaltung 30 mit Übertragern 51 bis 54 zur galvanischen Potentialtrennung zwischen einem primärseitigen 4 und vier sekundärseitigen Schaltungsteilen 6. Der Drei-Level-Inverter 10 besteht aus der Reihenschaltung von vier anzusteuernden Halbleiterschaltern , hier jeweils ausgebildet als IGBTs T1 bis T4 mit zugeordneten antiparallel geschalteten Freilaufdioden D1 bis D4 sowie mit zwei Begrenzungsdioden D5, D6. Der Drei-Level-Inverter 10 wird durch zwei in Reihe geschaltete gleiche Hochspannungszwischenkreiskondensatoren C1, C2, mit dem positiven Spannungsanschluss +DC und dem negativem Spannungsanschluss -DC gespeist. Die gemeinsame Verbindung der Zwischenkreiskondensatoren wird als Neutralknoten N bezeichnet und ist im Allgemeinen geerdet. Die zweite Begrenzungsdiode D6 begrenzt die Spannung am Emitter E3 des dritten IGBTs T3 und damit auch die Spannung am Wechselspannungsanschluss AC derart, dass sie nur Werte zwischen denjenigen des Neutralknotens N und des positiven Spannungsanschlusses +DC annehmen kann. Die erste Begrenzungsdiode D5 begrenzt die Spannung am Emitter E2 des zweiten IGBT T2 und damit auch die Spannung am Wechselspannungsanschluss AC derart, dass sie nur Werte zwischen denjenigen des negativen Spannungsanschlusses -DC und des Neutralknotens N annehmen kann. Aufgrund dieser Begrenzung von Spannungen am Neutralknoten N bezeichnet man die Topologie als NPC (Neutral Point Clamped)-Topologie. Drei-Level-Inverter 10 in NPC-Topologie haben den Vorteil, dass zum Erreichen der gewünschten Spannungsfestigkeit Bauelemente eingesetzt werden können, deren Durchbruchspannung niedriger ist als die gesamte Zwischenkreisspannung. Beispielhaft können für einen Drei-Level-Inverter der Spannungsklasse 1200V Bauelemente der Spannungsklasse 600V eingesetzt werden.

Die Ansteuerschaltung 30 besteht aus mehreren Teilschaltungen bzw. Funktionsblöcken. Die Ansteuersignale von einer übergeordneten, nicht dargestellten Schaltung, werden in der Ansteuerlogik 40 des primärseitigen Schaltungsteils 4 aufbereitet. Das Referenzpotential 400 der Ansteuerlogik 40 liegt dabei auf dem geerdeten Neutralknoten N. Die Übertragung der Ansteuersignale erfolgt mittels galvanisch trennender Potentialtrennglieder, hier mittels Übertragern 51 bis 54 zu, den jeweiligen sekundärseitigen Schaltungsteilen 6. Die Treiberstufen 61 bis 64 der jeweiligen sekundärseitigen Schaltungsteile 6 steuern die IGBTs T1 bis T4 entsprechend der übertragenen Ansteuersignale an. Dabei sind die Bezugspotentiale 610, 620, 630, 640 der Treiberstufen 61 bis 64 jeweils mit dem Emitter E1 bis E4 des zugeordneten anzusteuernden IGBTs T1 bis T4 verbunden. Die Funktionsblöcke der Ansteuerschaltung 30 sind nach dem Stand der Technik diskret auf einer Leiterplatte aufgebaut.

Fig. 2 zeigt eine zweite Topologie eines Drei-Level-Inverters 20 nach dem Stand der Technik mit dazugehöriger Ansteuerschaltung 30, die grundsätzlich analog zu Fig. 1 ausgestaltet ist. Der Drei-Level-Inverter 20 besteht aus einer Halbbrückenschaltung des ersten und vierten Halbleiterschalters, jeweils ausgebildet als IGBTs T1, T4 mit dazugehörigen Freilaufdioden D1, D4, sowie einer Reihenschaltung der zweiten und dritten Halbleiterschalter zwischen dem Wechselspannungsanschluss AC und dem Neutralknoten N, wobei die Emitter E2, E3 der IGBTs T2, T3 des zweiten und dritten Halbleiterschalters miteinander verbunden sind. Dieser Drei-Level-Inverter 20 wird ebenfalls durch zwei in Reihe geschaltete gleiche Hochspannungszwischenkreiskondensatoren C1, C2 mit dem positiven Spannungsanschluss +DC und dem negativem Spannungsanschluss -DC gespeist. Die gemeinsame Verbindung der Zwischenkreiskondensatoren, der Neutralknoten N, ist im Allgemeinen geerdet. Wenn der zweite IGBT T2 eingeschaltet ist, wird die Spannung am Wechselspannungsanschluss AC durch die dritte Diode D3 derart begrenzt, dass sie nur Werte zwischen denjenigen des Neutralknotens N und des positiven Spannungsanschlusses +DC annehmen kann. Wenn der dritte IGBT T3 eingeschaltet ist, wird in analoger Weise die Spannung am Wechselspannungsanschluss AC durch die zweite Diode D2 derart begrenzt, dass sie nur Werte zwischen denjenigen des negativen Spannungsanschlusses -DC und des Neutralknotens N annehmen kann. Auch hier liegt eine Topologie mit Begrenzung von Spannungen am Neutralknoten N vor. Aufgrund ihres T-förmigen Schaltbildes wird sie als TNPC (T-type Neutral Point Clamped) - Topologie bezeichnet. Drei-Level-Inverter 20 in TNPC-Topologie haben gegenüber Drei-Level-Invertern in NPC-Topologie, vgl. Fig. 1, den Vorteil, dass die zusätzlichen Begrenzungsdioden D5, D6 nicht benötigt werden. Nachteilig ist hingegen, dass zum Erreichen der gewünschten Spannungsfestigkeit Bauelemente für den ersten und vierten Leistungsschalter T1, D1, T4, D4 eingesetzt werden müssen, deren Durchbruchspannung gleich oder bevorzugt geringfügig größer ist als die gesamte Zwischenkreisspannung. Beispielhaft müssen für einen Drei-Level-Inverter der Spannungsklasse 1200V auch Bauelemente der Spannungsklasse 1200V, wobei diese fachüblich eine geringfügig höhere Spannungsfestigkeit aufweisen, eingesetzt werden.

Zur Ansteuerung von Drei-Level-Invertern 20 in TNPC-Topologie wird eine Ansteuerschaltung 30 eingesetzt, wie zur Ansteuerung von Drei-Level-Invertern 10 in NPC-Topologie gemäß Fig. 1. Allerdings sind die Bezugspotentiale 620, 630 der zweiten und dritten sekundärseitigen Schaltungsteile 62, 63 mit dem gleichen Potential, demjenigen der Emitter E2, E3 des zweiten und dritten IGBTs T2, T3 verbunden.

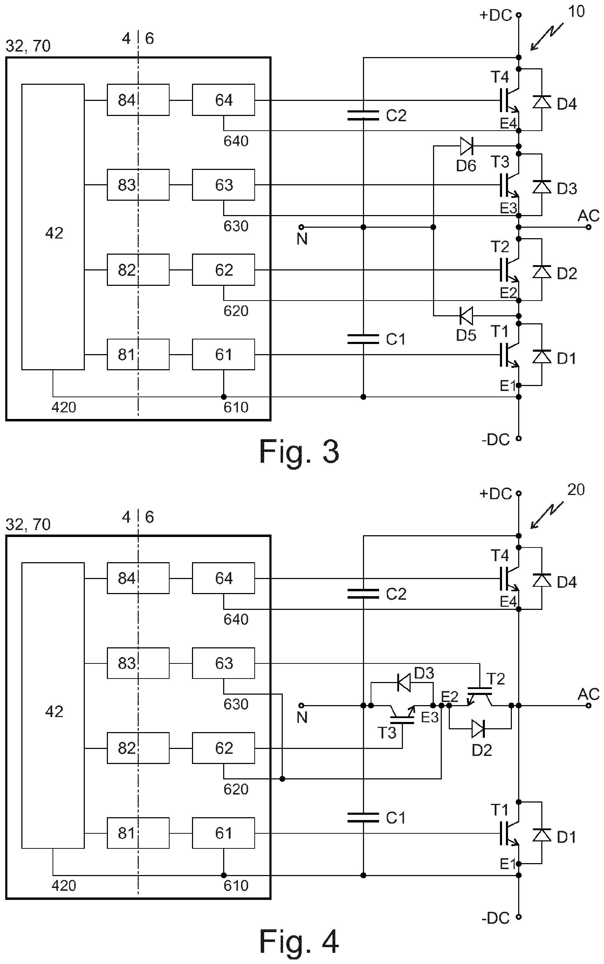

Fig. 3 zeigt eine erfindungsgemäße Ansteuerschaltung 32 zur Ansteuerung eines Drei-Level-Inverters 10 in erster, also in NPC-, Topologie mit symmetrisch geerdetem Zwischenkreis. Die erfindungsgemäße Ansteuerschaltung 32 mit einem primärseitigen Schaltungsteil 4 und vier sekundärseitigen Schaltungsteilen 6 wird mit Hilfe integrierter Schaltungstechnik in einem HVIC (High Voltage Integrated Circuit) 70 realisiert und umfasst somit auch die Potentialtrennung in einer einzigen monolithisch integrierten Schaltung. Die potentialgetrennte Übertragung der Ansteuersignale von dem primärseitigen Schaltungsteil 4 mit der Ansteuerlogik 42 zu den jeweiligen sekundärseitigen Schaltungsteilen 6 mit den Treiberstufen 61 bis 64 erfolgt mittels Levelshifter 81 bis 84. Die mögliche Integration der gesamten Ansteuerschaltung 32 für Drei-Level-Inverter 10 in einem Gehäuse, beispielhaft einem Standard-IC-Gehäuse mit entsprechenden Isolationsabständen der Pins, bildet einen bedeutenden Teil der erfindungsgemäßen Weiterbildung des Standes der Technik gemäß Fig. 1 und 2. Ebenso vorteilhaft ist die Möglichkeit der Anordnung des HVICs 70 direkt auf einer Leiterbahn eines metallisierten Keramiksubstrats eines Drei-Level-Leistungshalbleitermoduls, wodurch es möglich ist den Drei-Level-Inverter 10 und die Ansteuerschaltung 32 direkt im Leistungshalbleitermodul elektrisch zu verbinden.

Bei der erfindungsgemäßen Ansteuerschaltung 32 wird das primärseitige Bezugspotential 420 an das niedrigste Potential der gesamten Schaltungsanordnung also an dasjenige des negativen Spannungsanschlusses -DC oder in anderen Worten an das Bezugspotential des ersten Halbleiterschalters, ausgebildet mit dem ersten Transistor T1 angeschlossen.

Ausgehend von diesem Bezugspotential, also demjenigen Potential des negativen Spannungsanschlusses -DC, müssen zur potentialgetrennten Ansteuerung der IGBTs T1 bis T4 des Drei-Level-Inverters 10 in NPC-Topologie die folgenden Potentialdifferenzen zwischen dem primärseitigen Schaltungsteil 4 und den sekundärseitigen Schaltungsteilen 6 von den Levelshiftern 81 bis 84 überwunden werden:
Das Bezugspotential 610 der ersten Treiberstufe ist das Emitterpotential des ersten IGBTs T1 und damit auch das primärseitige Bezugspotential 420. Somit ist hier eine Signalübertragung über einen Hochvolt-Levelshifter nicht zwingend notwendig. Durch systeminterne Induktivitäten, beispielhaft Leitungsinduktivitäten im Leistungshalbleitermodul des Drei-Level-Inverters 10 oder in der Zuführung zur Ansteuerschaltung 32, kann es jedoch während des Schaltens der Halbleiterschalter zu einem starken Verriss des Emitterpotentials des ersten IGBTs T1 in positiver oder negativer Richtung kommen. Dies tritt in besonders starkem Maße in Leistungshalbleitersystemen mittlerer und hoher Leistung auf, bei denen große Ströme, beispielhaft größer 50A, geschaltet werden. Aufgrund der entstehenden Potentialdifferenz ist für eine sichere Signalübertragung ein MV (medium voltage) - Levelshifter 81 mit einer Spannungsfestigkeit von beispielhaft 20V bis 30V insbesondere mit UP- und DOWN- Charakteristik ausreichend.

Das Bezugspotential 620 der zweiten Treiberstufe 62 ist das Emitterpotential des zweiten IGBTs T2, welches zwischen demjenigen Potential des negativen Spannungsanschlusses -DC und des Neutralknotens N variiert. Die Spannungsfestigkeit des zweiten Levelshifters 82 muss demzufolge zumindest geringfügig höher sein als die Spannung die am ersten Zwischenkreiskondensator C1 anliegt.

Das Bezugspotential 630 der dritten Treiberstufe 63 ist das Emitterpotential des dritten IGBTs T3 und damit des Wechselspannungsanschlusses AC des Drei-Level-Inverters 10, dessen Potential zwischen demjenigen Potential des negativen -DC und positiven Spannungsanschlusses +DC variiert. Die Spannungsfestigkeit des dritten Levelshifters 83 muss demzufolge zumindest geringfügig höher sein als die Gesamtspannung die an den beiden Zwischenkreiskondensatoren C1, C2 anliegt.

Das Bezugspotential 640 der vierten Treiberstufe 64 ist das Emitterpotential des vierten IGBTs T4, welches zwischen demjenigen Potential des Neutralknotens N und des positiven Spannungsanschlusses +DC variiert. Die Spannungsfestigkeit des vierten Levelshifters 84 muss demzufolge ebenfalls zumindest geringfügig höher sein als die Gesamtspannung die an den beiden Zwischenkreiskondensatoren C1, C2 anliegt.

Fig. 4 zeigt die erfindungsgemäße Ansteuerschaltung 32 zur Ansteuerung eines Drei-Level-Inverters 20 in zweiter, also in TNPC-, Topologie mit symmetrisch geerdetem Zwischenkreis.

Ausgehend von dem gleichen Bezugspotential wie zu Fig. 3, also demjenigen Potential des negativen -DC sind im Folgenden nur gegenüber Fig. 3 unterschiedliche Ausgestaltungen beschrieben:
Bei dem Drei-Level-Inverter 20 in TNPC-Topologie sind die Emitter E2, E3 des zweiten und dritten IGBTs T2, T3 miteinander verbunden und haben somit das gleiche Bezugspotential 620, 630, welches zwischen denjenigen Potentialen des negativen Spannungsanschlusses -DC und des Neutralknotens N variiert. Die Spannungsfestigkeit des zweiten und dritten Levelshifter 82, 83 muss demzufolge zumindest geringfügig höher sein als die Spannung die am ersten Zwischenkreiskondensator C1 anliegt.

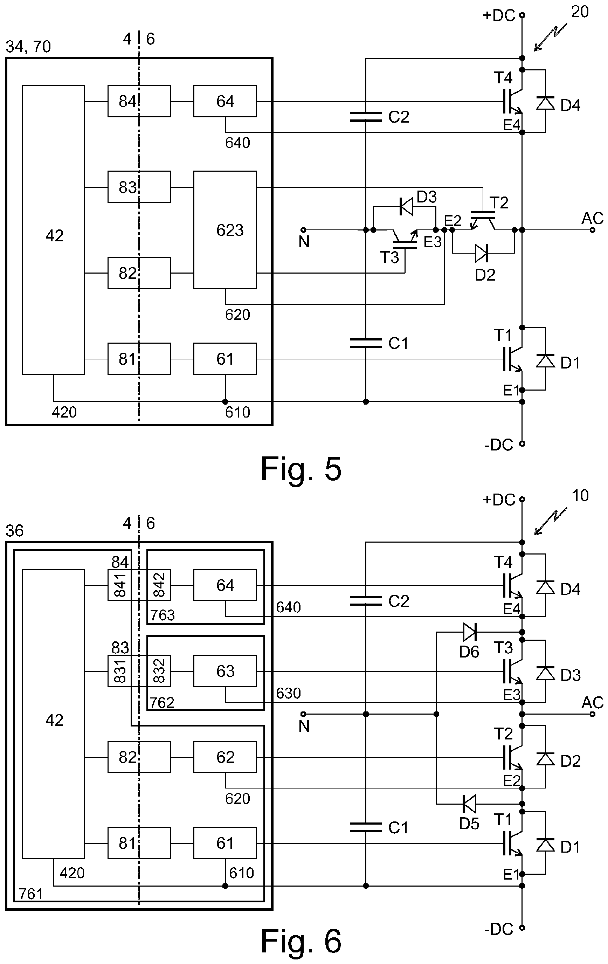

Fig. 5 zeigt eine Ansteuerschaltung 34, die gegenüber derjenigen gemäß Fig. 4 modifiziert ist. Da bei Drei-Level-Invertern 20 in TNPC-Topologie die Emitter E2, E3 der zweiten und dritten IGBTs T2, T3 miteinander verbunden sind und somit das gleiche Bezugspotential 620, 630 besitzen, können die zweiten und dritten Treiberstufen zu einer gemeinsamen Treiberstufe 623 zusammengefasst werden.

Ist die Spannungsfestigkeit der monolithisch integrierbaren Hochspannungsbauelemente und damit insbesondere der HV-Levelshifter geringer als die Gesamtspannung, die an den beiden Zwischenkreiskondensatoren C1, C2 anliegt, kann eine erweiterte Levelshiftertopologie, ausgeführt als eine Reihenschaltung von HV-Transistoren, eingesetzt werden, um die geforderte Spannungsfestigkeit zu erreichen. Da in den meisten Fällen die Durchbruchspannung der Isolation der HVIC-Technologie und die der HV-Transistoren annähernd gleich groß sind, kann die Spannungsfestigkeit der gesamten Levelshifteranordnung nur um einen Faktor erhöht werden, wenn jeder der HV-Transistoren auf einem separaten und von den anderen isolierten Substrat angeordnet wird.

Fig. 6 zeigt eine weitere erfindungsgemäße Ansteuerschaltung 36 zur Ansteuerung von Drei-Level-Invertern 10, insbesondere in NPC-Topologie, für eine Spannungsklasse, hier beispielhaft 1200V, die die Spannungsfestigkeit der verfügbaren HVIC-Technologie, hier beispielhaft 600V übersteigt. Durch die Anwendung der erweiterten Levelshiftertopologie mit der Reihenschaltung von jeweils zwei Teillevelshiftern 831, 832 und 841, 842 kann die benötigte Spannungsfestigkeit von 1200V zur Ansteuerung des dritten und vierten IGBTs T3, T4 erreicht werden. Die Ansteuerschaltung besteht dabei aus drei HVICs, wobei ein erster HVIC 761 die Ansteuerschaltung 42, den ersten und zweiten Levelshifter 81, 82 sowie die erste und zweite Treiberstufe 61, 62 und zwei Teillevelshifter 831, 841, die jeweils ein Teil des dritten bzw. vierten Levelshifters 83, 84 ausbilden, aufweist. Der zweite Levelshifter 82 weist hierbei eine Spannungsfestigkeit von beispielhaft 600V auf. Der zweite und dritte HVIC 761, 762 weist jeweils den zweiten Teillevelshifter 832, 842 des dritten und vierten Levelshifters 83, 84 auf. Die jeweiligen Teillevelshifter 831, 832, 841, 842 weisen ebenfalls eine Spannungsfestigkeit von beispielhaft 600V auf. Die HVICs 761, 762, 763 können in einem modifiziertem Standard-IC-Gehäuse, einem sog. Multichipmodul, auf voneinander isolierten Inseln angeordnet werden. Die elektrische Verbindung zwischen den einzelnen Chips kann mit einem Drahtbond-Verfahren erreicht werden. Weiterhin möglich ist der Aufbau der jeweiligen HVICs 761, 762, 763 auf voneinander isolierten Leiterbahnen eines metallisierten Keramiksubstrats eines Drei-Level-Leistungshalbleitermoduls.

Diese Ansteuerschaltung 36 kann grundsätzlich auch für Drei-Level-Inverter 20 in TNPC-Topologie eingesetzt werden, wobei ggf. nur zwei HVICs notwendig werden.

## Patentansprüche

1. Ansteuerschaltung (32, 34, 36) mit einem primärseitigen Schaltungsteil (4) mit einer Ansteuerlogik (42) und einem primärseitigen Bezugspotential (420) und vier sekundärseitigen Schaltungsteilen (6) jeweils mit einer Treiberstufe (61, 62, 63, 64) ausgebildet zur Ansteuerung einer Phase eines Drei-Level-Inverters (10, 20) mit jeweils einem ersten bis vierten Halbleiterschalter (T1, D1 T2, D2, T3, D3, T4, D4), wobei jeder Halbleiterschalter und der ihm zugeordnete sekundärseitige Schaltungsteil (6) ein zugeordnetes erstes bis viertes sekundärseitiges Bezugspotential (610, 620, 630, 640) aufweist, wobei jeweils ein Levelshifter (81, 82, 83, 84) den primärseitigen Schaltungsteil (4) mit dem jeweiligen sekundärseitigen Schaltungsteil (6) verbindet und somit jeweils beiden Schaltungsteilen zugeordnet ist, wobei das primärseitige Bezugspotential (420) dem ersten sekundärseitigen Bezugspotential (610) sowie demjenigen des negativen Spannungsanschlusses (-DC) des Drei-Level-Inverters (10, 20) entspricht und
wobei zumindest die Ansteuerlogik (42), der erste und zweite Levelshifter (81, 82) sowie die erste und zweite Treiberstufe (61, 62) monolithisch in einem HVIC (70) integriert sind.

2. Ansteuerschaltung nach Anspruch 1, wobei
die Halbleiterschalter des Drei-Level-Inverters in Reihe oder in T-Topologie geschaltet sind und wobei der erste Halbleiterschalter (T1, D1) mit einem negativen Spannungsanschluss (-DC) und der vierte Halbleiterschalter (T4, D4) mit einem positiven Spannungsanschluss (+DC) des Drei-Level-Inverters verbunden sind.

3. Ansteuerschaltung nach einem der Ansprüche 1 oder 2, wobei
die Ansteuerschaltung (42) sowie alle Levelshifter (81, 82, 83, 84) und alle Treiberstufen (61, 62, 63, 64) monolithisch integriert sind.

4. Ansteuerschaltung nach einem der Ansprüche 1 oder 2, wobei
der dritte und vierte Levelshifter (83, 84) aus jeweils zwei Teillevelshiftern (831, 832, 841, 842) ausgebildet ist, wobei der jeweils erste Teillevelshifter (831, 841) gemeinsam mit der Ansteuerlogik (42) und dem ersten und zweiten Levelshifter (81, 82) und der ersten und zweiten Treiberstufe (61, 62) auf einem ersten HVIC (761) monolithisch integriert sind, und wobei die jeweils zweiten Teillevelshifter (832, 842) mit der zugeordneten Treiberstufe (63, 64) monolithisch in einem eigenen, dem zweiten oder dritten HVIC (762, 763) integriert sind.

5. Ansteuerschaltung nach Anspruch 4, wobei
der erste, zweite und dritte HVIC (761, 762, 763) in einem Multichipmodul mit gemeinsamen Gehäuse verbaut sind, oder jeder HVIC auf einer Leiterbahn angeordnet ist, die zu den anderen Leiterbahn eines Leistungshalbleitermoduls elektrisch isoliert ist.

6. Ansteuerschaltung nach einem der vorhergehenden Ansprüche, wobei mindestens ein Levelshifter (81, 82, 83, 84) dazu ausgebildet ist ein Ansteuersignal von dem primärseitigen Schaltungsteil (4) zum zugeordneten sekundärseitigen Schaltungsteil (6) unidirektional zu übertragen oder dazu ausgebildet ist ein Ansteuersignal und ein Rücksignal zu übertragen und somit eine bidirektionale Übertragung bereitzustellen.

7. Ansteuerschaltung nach einem der vorhergehenden Ansprüche, wobei
ein Halbleiterschalter ausgebildet ist aus mindestens einem Leistungstransistor (T1, T2, T3, T4), insbesondere einem IGBT mit antiparallel geschalteter Freilaufdiode (D1, D2, D3, D4).

8. Ansteuerschaltung nach Anspruch 7, wobei
wobei das Potential des Emitter (E1, E2, E3, E4) das Bezugspotential des jeweiligen IGBTs (T1, T2, T3, T4) darstellt.

9. Ansteuerschaltung nach einem der vorhergehenden Ansprüche, wobei
die monolithische Integration in SOI- Technologie erfolgt.

## Claims

1. Actuating circuit (32, 34, 36) having a primary-side circuit part (4) with an actuating logic circuit (42) and a primary-side reference potential (420) and four secondary-side circuit parts (6) with in each case one driver stage (61, 62, 63, 64) designed for actuating a phase of a three-level inverter (10, 20) with in each case a first to fourth semiconductor switch (T1, D1, T2, D2, T3, D3, T4, D4), wherein each semiconductor switch and the secondary-side circuit part (6) assigned thereto has an assigned first to fourth secondary-side reference potential (610, 620, 630, 640), wherein in each case a level shifter (81, 82, 83, 84) connects the primary-side circuit part (4) to the respective secondary-side circuit part (6) and thus is assigned in each case to both circuit parts, wherein the primary-side reference potential (420) corresponds to the first secondary-side reference potential (610) and to that of the negative voltage connection (-DC) of the three-level inverter (10, 20) and wherein at least the actuating logic circuit (42), the first and second level shifters (81, 82) and the first and second driver stages (61, 62) are monolithically integrated in an HVIC (70).

2. Actuating circuit according to Claim 1, wherein the semiconductor switches of the three-level inverter are connected in series or in T-type topology and wherein the first semiconductor switch (T1, D1) is connected to a negative voltage connection (-DC) and the fourth semiconductor switch (T4, D4) is connected to a positive voltage connection (+DC) of the three-level inverter.

3. Actuating circuit according to either of Claims 1 and 2, wherein
the actuating circuit (42) and all of the level shifters (81, 82, 83, 84) and all of the driver stages (61, 62, 63, 64) are monolithically integrated.

4. Actuating circuit according to either of Claims 1 and 2, wherein
the third and fourth level shifters (83, 84) are formed from in each case two partial level shifters (831, 832, 841, 842), wherein the respective first partial level shifter (831, 841) is monolithically integrated together with the actuating logic circuit (42) and the first and second level shifters (81, 82) and the first and second driver stages (61, 62) on a first HVIC (761), and wherein the respective second partial level shifter (832, 842) is monolithically integrated with the assigned driver stage (63, 64) in a separate, the second or third HVIC (762, 763).

5. Actuating circuit according to Claim 4, wherein
the first, second and third HVICs (761, 762, 763) are built into a multi-chip module with common housing, or each HVIC is arranged on a conductor track which is electrically isolated with respect to the other conductor tracks of a power semiconductor module.

6. Actuating circuit according to any of the preceding claims, wherein
at least one level shifter (81, 82, 83, 84) is designed to transmit one actuation signal from the primary-side circuit part (4) to the assigned secondary-side circuit part (6) in a unidirectional manner, or is designed to transmit an actuation signal and a return signal and thus to provide bidirectional transmission.

7. Actuating circuit according to any of the preceding claims, wherein
a semiconductor switch is formed from at least one power transistor (T1, T2, T3, T4), in particular an IGBT with a freewheeling diode (D1, D2, D3, D4) connected back-to-back in parallel therewith.

8. Actuating circuit according to Claim 7, wherein
the potential of the emitter (E1, E2, E3, E4) is the reference potential of the respective IGBTs (T1, T2, T3, T4).

9. Actuating circuit according to any of the preceding claims, wherein
the monolithic integration is done in SOI technology.

## Revendications

1. Commutateur de commande (32,34,36) avec une partie de circuit du côté primaire (4) avec une logique de commande (42) et un potentiel de référence du côté primaire (420) et quatre parties de circuits du côté secondaire (6) respectivement avec un étage pilote (61,62,63,64) constitué pour commander une phase d'un onduleur à trois niveaux (10,20) avec respectivement un premier jusqu'à un quatrième commutateur statique (T1,D1,T2,D2,T3,D3,T4,D4), chaque commutateur statique et la partie de circuit du côté secondaire (6) qui lui est attribuée comportant un premier jusqu'à un quatrième potentiel de référence du côté secondaire (610,620,630,640) associé, un compensateur de niveau (81,82,83,84) reliant respectivement la partie de circuit du côté primaire (4) à la partie de circuit du côté secondaire respective (6) et étant de ce fait attribué respectivement aux deux parties de circuit, le potentiel de référence du côté primaire (420) correspondant au premier potentiel de référence du côté secondaire (610) ainsi qu'à celui de la connexion de tension négative (-CC) de l'onduleur à trois niveaux (10,20) et au moins la logique de commande (42), le premier et deuxième compensateur de niveau (81,82) ainsi que le premier et le deuxième étage pilote (61,62) étant intégrés de manière monolithique dans un circuit intégré à haute tension (CIHT)(70).

2. Commutateur de commande selon la revendication 1, les commutateurs statiques de l'ondulateur à trois niveaux étant connectés en série ou en topologie T et le premier commutateur statique (T1,D1) étant relié à une connexion de tension negative (-CC) et le quatrième commutateur statique (T4,D4) à une connexion de tension positive (+CC) de l'onduleur à trois niveaux.

3. Commutateur de commande selon l'une quelconque des revendications 1 ou 2, le commutateur de commande (42) ainsi que tous les compensateurs de niveau (81,82,83,84) et tous les étages pilotes (61,62,63,64) étant intégrés de manière monolithique.

4. Commutateur de commande selon l'une quelconque des revendications 1 ou 2, le troisième et le quatrième compensateur de niveau (83,84) étant constitués à partir respectivement de deux compensateurs de niveau partiels (831,832,841,842), le premier compensateur de niveau partiel (831,841) avec la logique de commande (42) et le premier et le deuxième compensateur de niveau (81,82) et le premier et le deuxième étage pilote (61,62) étant intégrés de manière monolithique sur un premier CIHT (761) et les deuxièmes compensateurs de niveau partiels respectifs (832,842) avec l'étage piloté attribué (63,64) étant intégrés de manière monolithique dans un deuxième ou troisième CIHT propre (762, 763) .

5. Commutateur de commande selon la revendication 4, le premier, deuxième et troisième CIHT (761,762,763) étant montés dans un module multipuces avec un boîtier commun ou chaque CIHT étant disposé sur une piste conductive, qui est électriquement isolée par rapport aux autres pistes conductives d'un module à semi-conducteurs de puissance.

6. Commutateur de commande selon l'une quelconque des revendications précédentes, au moins un compensateur de niveau (81,82,83,84) étant à cet effet constitué pour transmettre de manière unidirectionnelle un signal de commande de la partie de circuit du côté primaire (4) à la partie de circuit du côté secondaire attribuée (6) ou étant constitué à cet effet pour transmettre un signal de commande et un signal de retour et fournir ainsi une transmission bidirectionnelle.

7. Commutateur de commande selon l'une quelconque des revendications précédentes, un commutateur statique étant constitué à partir d'au moins un transistor de puissance (T1,T2,T3,T4), notamment un transistor bipolaire à grille isolée (IGBT) avec diode de marche à vide (D1,D2,D3,D4) connectée de manière antiparallèle.

8. Commutateur de commande selon la revendication 7, le potentiel de l'émetteur (E1,E2,E3,E4) représentant le potentiel de référence du transistor bipolaire à grille isolée (IGBT) respectif (T1,T2,T3,T4).

9. Commutateur de commande selon l'une quelconque des revendications précédentes, l'intégration monolithique ayant lieu dans une technologie silicium sur isolant (SOI).
